(19)

Europäisches
Patentamt
European
Patent Office
Office européen
des brevets

(11) **EP 2 498 310 A2**

(12) **EUROPEAN PATENT APPLICATION**

(43) Date of publication:
   **12.09.2012 Bulletin 2012/37**

(51) Int Cl.:
   **H01L 35/30** (2006.01)

(21) Application number: **12158746.3**

(22) Date of filing: **09.03.2012**

(84) Designated Contracting States:
   **AL AT BE BG CH CY CZ DE DK EE ES FI FR GB
   GR HR HU IE IS IT LI LT LU LV MC MK MT NL NO
   PL PT RO RS SE SI SK SM TR**
   Designated Extension States:
   **BA ME**

(30) Priority: **11.03.2011 US 201161451689 P**

(71) Applicant: **IMEC
   3001 Leuven (BE)**

(72) Inventor: **Leonov, Vladimir
   3010 Leuven (BE)**

(74) Representative: **Hertoghe, Kris Angèle Louisa et al
   DenK iP bvba
   Hundelgemsesteenweg 1114
   9820 Merelbeke (BE)**

(54) **Thermoelectric textile**

(57)    A thermoelectric system comprises:
- a flexible structure (121);
- at least one thermocouple unit (120) integrated in or attached to the flexible structure (121), each thermocouple unit (120) comprising at least one thermocouple (10) and at least one radiator element (90), the at least one radiator element (90) being thermally connected to a first end (10a) of the thermocouple (10); wherein the at least one radiator element (90) is flexible. The flexibility of the radiator elements (90) results in a good resistance to mechanical stress and shocks, and contributes to an improved wearing convenience.

**FIG. 1**

**EP 2 498 310 A2**

**Description**

**Field of the invention**

The present invention relates to thermoelectric systems, e.g. thermoelectric generator systems, comprising a bendable or flexible structure, such as for example textile or foil, and thermocouple units comprising at least one thermocouple integrated in the flexible structure. The present invention also relates to methods for manufacturing such thermoelectric systems.

**Background of the invention**

A thermoelectric generator (TEG) utilises a temperature difference occurring between a hot (warm) object, i.e. a heat source, and its colder surroundings, i.e. a heat sink, or vice versa, and can be used to transform a consequent heat flow into useful electrical power.

There is increasing interest in thermoelectric clothes, as well as in soft, flexible and washable TEGs which could power wearable devices integrated into garments, underwear, caps, belts or straps.

In "Smart wireless sensors integrated in clothing: an electrocardiography system in a shirt powered using human body heat", Sensors and Transducers Journal, Vol. 107, Issue 8 (2009), pp. 165-176, V. Leonov et al. report 6.5 mm thick TEG modules integrated in a shirt, for thermal conversion of a natural heat flow from the human body into electrical energy. An opening is cut into the textile for enabling integration of the rigid TEG modules in the shirt. A cold plate is provided at an outer side of the shirt at a distance of about 3 to 5 mm from the textile. A hot plate is located at an inner side of the shirt and is partly covered by the textile. The thermocouples are provided between the hot plate and the cold plate, through the opening in the textile. The rigid TEG modules used in this approach may lead to some wearing inconvenience and may not allow a good integration within the shirt.

Methods have been proposed for producing thermoelectric generators by weaving electro conductive threads of two different natures into textile, such as for example described in US 2004/0025930. Using this approach in wearable textile, the distance between the cold junctions and the hot junctions would be very small and would correspond to the textile thickness. In addition, there would be a non-efficient heat transfer between the skin and the hot junctions on one hand and between the cold junctions and the ambient on the other hand. Typically, the textile touches the skin only partially. This causes a high thermal resistance that is added in series with the thermocouple and therefore dramatically decreases the produced power. This leads to a very small temperature difference between the hot junctions and the cold junctions, and thus a limited output power.

**Summary of the invention**

It is an aim of the present invention to provide a thermoelectric system comprising thermocouple units integrated in or attached to a flexible or bendable structure, such as e.g. textile, with a good wearing convenience, a good heat transfer and/or a good output power. It is a further aim of embodiments of the present invention to provide methods for fabricating such thermoelectric systems.

The above objectives are accomplished by methods and devices according to embodiments of the present invention.

In a first aspect, the present invention provides a thermoelectric system comprising:

- a bendable or flexible structure; the bendable or flexible structure may have a first side and a second side whereover a temperature difference can be applied;
- at least one thermocouple unit integrated in or attached to the flexible structure, each thermocouple unit comprising at least one thermocouple and at least one radiator element, the at least one radiator element being thermally connected to a first end of the thermocouple and being arranged at least partly at the first side of the flexible structure for acting as a heat sink; wherein the at least one radiator element is bendable or flexible.

By providing a radiator element thermally connected to the thermocouple, the thermal resistance of the thermocouples towards the first side of the flexible structure is decreased, the heat dissipation of the heat sink is increased, and the heat flow through the thermocouple is increased. When used as a thermoelectric generator, the electrical output power may thus be increased.

The flexibility of the radiator elements results in a good resistance to mechanical stress and shocks. The flexibility of the radiator elements may furthermore contribute to an improved wearing convenience, especially in comparison with e.g. a system having a metal or ceramic plate radiator. In addition, as the radiator element is flexible or bendable, the need for making a relatively large opening (e.g. 3cm x 4cm) in the flexible structure can be omitted.

As used herein, the first side of the bendable or flexible structure, is further also called the "cold" side, or the side of the heat sink. In case of clothing being worn, it can be the outside of the clothing that is oriented towards, close to, exposed to, or in contact with the outside ambient environment.

As used herein, the second side of the bendable or flexible structure, is further also called the "hot" or "warm" side, or the side of the heat source. In case of clothing being worn, it can be the inside of the clothing that is oriented towards, close to, exposed to, or in contact with a human body.

In embodiments of the present invention, the bendable or flexible structure may be substantially planar, and its first and second sides may be opposite sides in a direction perpendicular to the plane, i.e. in the thickness direction of the flexible or bendable structure. For example, clothing is substantially planar (at least locally), and when worn on a human body, a temperature gradient occurs in a direction substantially perpendicular to the surface of the clothing.

In embodiments of the present invention, the at least one thermocouple comprises a first thermocouple leg made of a first thermoelectric material, and a second thermocouple leg made of a second thermoelectric material. The first thermocouple leg and the second thermocouple leg have a first end, for connection to a heat sink and a second end, for connection to a heat source. The first end of the first thermocouple leg may be electrically connected to the first end of the second thermocouple leg by means of a first electrically conductive element; the radiator element being thermally connected to the first ends of the first and second thermocouple legs.

The electrically conductive element may e.g. be a solder joint, or a metal strip, or a metal wire, etc.

In embodiments of the present invention, the first electrically conductive element can also function as a flexible radiator element, i.e. in this case the first electrically conductive element and the flexible radiator element may be the same element.

In other embodiments of the present invention the flexible radiator element can be a separate element being electrically insulated and thermally connected to the first electrically conductive element. In such embodiments, an electrically insulating joint can be provided for electrically insulating but thermally connecting the first electrically conductive element and the flexible radiator element. In this case the flexible radiator element is not the same element as the first electrical connection element. It is an advantage of electrically insulating the flexible radiator element from the first electrically conductive element that electrical shunting of thermocouples can be avoided, which would decrease the output voltage of a series connection of thermocouples.

The first thermocouple legs and the second thermocouple legs can be at least partially embedded in the flexible element or they can be provided outside the flexible element.

The flexible radiator element can have a wire shape or a film shape or any other suitable shape known to a person skilled in the art. It can be made of a thermally conductive material or it can comprise two or more wires or layers, e.g. two or more metal wires or metal layers. The flexible radiator element can also comprise a thermally insulating material in addition to a thermally conductive material. The flexible radiator element can be coated with an electrically insulating material, thereby avoiding electrical shunting of thermocouple units.

The flexible radiator element may be coated with an electrically insulating material, thereby avoiding electrical shunting of thermocouples.

In embodiments of the present invention, the thermocouple unit may further comprise a thermally insulating reinforcing structure for protecting the thermocouple legs, e.g. surrounding the thermocouple legs, and attached to or embedded in the flexible structure.

In particular embodiments of the present invention, the flexible radiator element has a wire shape. A wire shape has the advantage that it may have only a very small cross section, and thus a very small opening in the flexible structure (e.g. a knitting structure) may be sufficient for passing the radiator wire, without cutting and removing material from the clothing. By selecting a suitable length and/or cross section, the wires can considerably decrease the thermal resistance of the system, and thus increase the electrical output power in case of a thermoelectric generator integrated in clothing.

In alternative embodiments, the flexible radiator element has a film shape, or a strip shape. A film has the advantage that it can comprise multiple layers with different characteristics (e.g. thermally conductive, electrical insulation), while still being bendable or flexible, and it is easy to produce. An advantage over a wire is that it may have a larger contact area, thus a lower thermal resistance to the heat source (e.g. the human body) or heat sink (e.g. the environment). An advantage of a film shaped radiator element is that it may extend outside of the flexible structure (e.g. clothing) by passing it through a slit, instead of having to make a large opening.

In an embodiment the flexible radiator element comprises an area enlargement element for improving a heat flow through the thermocouple. Such an area enlargement element can further increase the heat dissipation, and thus decrease the thermal resistance of the system, and improve the heat flow through the thermocouple(s).

In embodiments of the present invention each thermocouple unit comprises a single thermocouple, and its flexible radiator element can be a wire-shaped radiator thermally connected to the single thermocouple.

In alternative embodiments, each thermocouple unit comprises a plurality of thermocouples electrically connected in series by means of electrically conductive elements, which may be arranged at the second side of the flexible structure. In this way, a thermocouple unit may have a single radiator element which is thermally connected to a plurality of thermocouples at their first end thus acting as a thermal shunt at the "cold side". This may make the temperature of the thermocouples at their first ends (i.e. the "cold junctions") more uniform, which may increase the heat flow through the thermocouple unit.

In particular embodiments, the flexible radiator element can be a film-shaped radiator element thermally connected to the plurality of thermocouples. Alternatively the flexible radiator elements of the plurality of thermocouple units can be thermally insulated from each other.

In embodiments of the present invention, the thermocouple unit with a plurality of thermocouples electrically connected in series further comprises a thermal shunt for thermally connecting the second ends of the plurality of thermocouples. Such a thermal shunt may make the temperature of the thermocouples at their second ends (i.e. the "hot junctions") more uniform, which may further increase the heat flow through the thermocouple unit.

In embodiments of the present invention, the thermocouple unit may further comprise at least one spacer arranged at the second side of the flexible structure for providing at least a predetermined distance between a heat source and the thermocouples. This may help to increase the heat flow through the thermocouples, by reducing heat flow in other pads. The spacers may e.g. be insulating bumps or pads or tubes. The thermocouples can be provided inside the pads or tubes, or outside the pads or tubes.

Embodiments of the present invention relate to thermoelectric generators comprising a plurality of thermocouple units according to the first aspect. The plurality of thermocouple units can be electrically connected at their second side opposite to the first side, e.g. by a second electrically conductive element. The flexible radiator elements of the plurality of thermocouple units can be thermally insulated from each other.

In particular embodiments, the present invention relates to thermoelectric generators comprising a plurality of thermocouples, wherein the thermoelectric generators are integrated with a textile layer, the textile layer being provided at and covering a cold side of the plurality of thermocouples. It was surprisingly found that the presence of the textile layer covering the "cold side" of the plurality of thermocouples leads to an improved heat flow through the plurality of thermocouples. This finding goes against the common believe that a textile layer is a thermally insulating layer, and thus adding such a layer would increase the thermal resistance and decrease the heat flow, but the opposite is true. This indicates that the textile layer may lead to heat spreading, and that the textile layer can act as a "cold plate". In an embodiment, the textile layer is in direct contact with the first ends of the thermocouples and/or with the first electrical conductors connected thereto.

A thermoelectric generator according to embodiments of the present invention may comprise a heat distributing element between the plurality of thermocouples and the textile layer. The heat distributing element is a thermally conductive layer leading to an improved heat transfer between the plurality of thermocouples and the textile. It may for example be attached to the textile layer by means of thermally conductive glue. In a thermoelectric generator according to embodiments of the present invention, thermally conductive wires may be integrated in the textile layer.

The thermoelectric generator system may further comprise a heat distribution element arranged between the thermocouples and the textile layer.

In an embodiment, the heat distributing element is a thermally conductive layer attached to the textile layer my means of thermally conductive glue.

Preferably also the flexible radiator comprises thermally conductive wires integrated in the textile layer.

By adding any of a heat distribution element or a thermally conductive layer, or by integrating the radiator wires into the textile layer, the heat transfer to the textile layer and the heat spreading in the textile layer can be further increased, and thus the thermal resistance decreased, and thus the output power of the thermoelectric generator for a given temperature difference further increased.

In a second aspect, the present invention provides a method for producing such a thermoelectric system.

A method according to embodiments of the present invention comprises:

a) providing a bendable or flexible structure;
b) providing at least one thermocouple unit comprising at least one thermocouple and at least one flexible radiator element thermally connected to a first end of the thermocouple, and
c) integrating or attaching the at least one thermocouple into or to the flexible structure.

In a method according to embodiments of the present invention, providing at least one thermocouple unit may comprise providing a thermoelectric wire with an alternating pattern of different elements electrically connected to one another in the following sequence: a first thermocouple leg, a first electrically conductive element, a second thermocouple leg and a second electrically conductive element. Integrating or attaching the at least one thermocouple unit into or to the flexible structure may comprise weaving the thermoelectric wire into the bendable or flexible structure, which in particular embodiments may be textile material, such that the first resp. second electrically conductive elements are arranged at least partly at different sides of the flexible structure.

In alternative embodiments, in a method according to the present invention providing a flexible structure may comprise providing a thermally and electrically insulating foil or tape, and providing at least one thermocouple unit may comprise providing at least two thermocouples on the foil or tape and electrically connecting the at least two thermocouples in series by means of an electrical connection. The method may further comprise providing at least one patterned thermally conductive layer for forming at least one radiator element, and thermally connecting the patterned thermally conductive layer to first ends of the thermocouple legs of the thermocouples.

Embodiments of the present invention provide a method for fabricating a thermocouple unit according to the first aspect. Such method may comprise weaving a thermoelectric wire into a flexible element such as textile, wherein the thermoelectric wire comprises an alternating pattern of different elements in the following sequence: a second electrically conductive element; a first thermocouple leg; a radiator wire, also functioning as a first electrically conductive element; and a second thermocouple leg. After weaving, the second electrically conductive element can be embedded into the textile or it can be provided on a surface of the textile. After weaving, the thermocouple legs can be embedded in the textile or they can be located outside the textile.

In further embodiments, the present invention provides a method for fabricating a thermocouple unit according to the first aspect on a thermally and electrically insulating foil or tape, e.g. on a polymer tape. A method according to such embodiments may comprise: providing at least one thermocouple on a tape, and providing at least one patterned thermally conductive layer for forming at least one radiator element thermally connected to a first side of the at least one thermocouple. Providing the at least one thermocouple on the tape may comprise providing at least one first thermocouple leg made of a first thermoelectric material and at least one second thermocouple leg made of a second thermoelectric material, providing at least one first electrically conductive element connecting the first thermocouple leg and the second thermocouple leg of a thermocouple at their first side, and providing at least one second electrically conductive element for connecting a first thermocouple leg of a thermocouple with a second thermocouple leg of another thermocouple at their second side. The method may further comprise providing a patterned layer of thermally conductive material for forming a thermal shunt, the thermal shunt being thermally connected to the second side of the at least one thermocouple.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example. those skilled in the art will recognize that the invention may be embodied or carried out in a manner that achieves or optimizes one advantage or group of advantages as taught herein without necessarily achieving other objects or advantages as may be taught or suggested herein. Further, it is understood that this summary is merely an example and is not intended to limit the scope of the invention as claimed. The invention, both as to organization and method of operation, together with features and advantages thereof, may best be understood by reference to the following detailed description when read in conjunction with the accompanying drawings.

**Brief description of the drawings**

FIG. 1 illustrates a thermoelectric generator system comprising four thermocouple units integrated into textile, according to an embodiment of the present invention.

FIG. 2 shows an example of a measured thermal resistance of a human leg as a function of heat flow.

FIG. 3 shows an embodiment of the present invention with a thermocouple unit integrated into textile, wherein the thermocouple legs are electrically insulated from a radiator wire.

FIG. 4 illustrates an embodiment of the present invention with a thermocouple wherein the thermocouple legs are electrically insulated from a radiator wire, and wherein a thermal shunt is provided for improving the thermal contact between the thermocouple and the radiator wire.

FIG. 5 illustrates an embodiment of the present invention with a thermocouple unit comprising a single thermocouple fabricated on a tape or foil.

FIG. 6 illustrates an embodiment of the present invention with a thermocouple unit comprising a plurality of thermocouples fabricated on a tape or foil.

FIG. 7 illustrates an embodiment of the present invention with a thermocouple unit fabricated on a tape or a foil, with electrical decoupling between the radiator elements and first electrically conductive elements, and comprising a thermal shunt at the hot side.

FIG. 8 and FIG. 9 illustrate steps in a fabrication process according to embodiments of the present invention for a thermoelectric generator (TEG) comprising a plurality of thermocouple units on a flexible tape.

FIG. 10 schematically shows an embodiment of a thermoelectric generator system according to the present invention, wherein the TEG comprises a plurality of rows of thermocouple units.

FIG. 11 shows a thermoelectric wire according to embodiments of the present invention and three examples illustrating weaving or integration of a thermoelectric wire into textile.

FIG. 12 illustrates a radiator wire with an area enlargement element according to embodiments of the present invention.

FIG. 13 shows two examples of radiator wires according to embodiments of the present invention, with different types of area enlargement elements.

FIG. 14, FIG. 15, FIG. 16 and FIG. 17 illustrate an exemplary method according to embodiments of the present invention for fabricating a thermocouple unit on an insulating tape, including a hot-side thermal shunt.

FIGS. 18 to 25 illustrate an embodiment of a method according to the present invention for fabricating a thermoelectric generator on an insulating roll-to-roll tape.

FIG. 26 shows examples of embodiments of the present invention with thermocouple units integrated into textile supplied with thermally insulating spacers and flexible thermal shunts.

FIG. 27 and FIG. 28 show examples of embodiments of the present invention with thermocouple units being provided in a tube made of thermally insulating tape.

FIG. 29 shows an example of an embodiment of the present invention with an arrangement with adjacent thermoelectric tubes attached to textile.

FIG. 30 shows a TEG according to embodiments of the present invention, with protection layers and with radiator wires woven in the textile.

FIG. 31 illustrates an embodiment of the present invention with thermoelectric tubes in combination with thermally insulating walls.

FIG. 32 illustrates an embodiment of the present invention with thermoelectric tubes with thermocouples inside.

Any reference signs in the claims shall not be construed as limiting the scope of the present invention.

In the different drawings, the same reference signs refer to the same or analogous elements.

## Detailed description of embodiments of the invention

In the following detailed description, numerous specific details are set forth in order to provide a thorough understanding of the invention and how it may be practiced in particular embodiments. However, it will be understood that the present invention may be practiced without these specific details. In other instances, well-known methods, procedures and techniques have not been described in detail, so as not to obscure the present invention. While the present invention will be described with respect to particular embodiments and with reference to certain drawings, the invention is not limited hereto. The drawings included and described herein are schematic and are not limiting the scope of the invention. It is also noted that in the drawings, the size of some elements may be exaggerated and, therefore, not drawn to scale for illustrative purposes.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B.

The present invention will be described with respect to particular embodiments, to particular applications and with reference to certain drawings but the invention is not limited thereto. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the invention.

The present invention relates to thermoelectric systems wherein thermocouples, thermocouple units and thermoelectric generators are integrated with a bendable or flexible element such as e.g. textile, a film or a foil. In the further description, the invention will be explained by means of an example of a thermoelectric system where thermocouple units and TEGs are integrated with textile, but the present invention is not limited thereto. The thermocouple units and/or TEGs may also be integrated with other bendable or flexible structures or elements such as for example glass fabric, foam sheets, polymer layers, plastic tubes. These thermoelectric integrated systems may be used on curved surfaces or in applications where flexibility is needed.

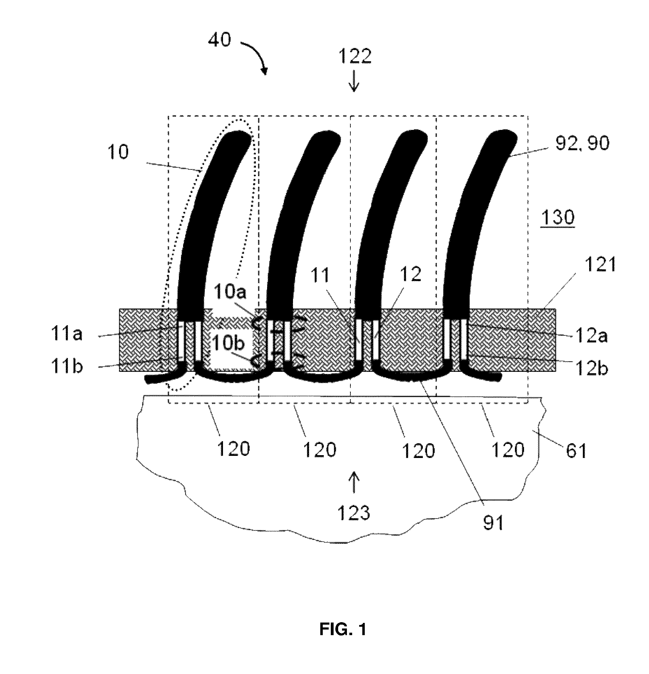

FIG. 1 shows a thermoelectric system according to embodiments of the present invention, with a TEG (thermoelectric generator) 40 integrated into flexible material such as textile 121. The TEG 40 comprises a plurality of thermocouple units 120. In the example shown in FIG. 1, the TEG 40 comprises four thermocouple units 120, and each thermocouple unit 120 comprises a single thermocouple 10 and a radiator element 90. Each thermocouple 10 comprises a first thermocouple leg 11 formed of a first thermoelectric material and a second thermocouple leg 12 formed of a second thermoelectric material. For example, the first leg 11 and the second leg 12 can be made of the same but oppositely doped thermoelectric material exhibiting low thermal conductance and low electrical resistance. Thermoelectric materials are known in the art, for example, the legs can be formed from BiTe alloys. If the first leg 11 is formed of n-type BiTe, then the second leg 12 may be formed of p-type BiTe and vice versa.

In the example shown in FIG. 1, the first thermocouple legs 11 and second thermocouple legs 12 are fully embedded in the textile 121. Alternatively (not shown) the first thermocouple legs 11 and/or the second thermocouple legs 12 may for example be partially embedded in the flexible structure, e.g. textile 121, or they may be located outside the flexible structure, e.g. textile. In the example shown in FIG. 1, the flexible or bendable structure 121 is substantially flat or planar, and the first thermocouple legs 11 and the second thermocouple legs 12 are oriented with their longitudinal axis in a direction substantially orthogonal to the plane of the flexible structure, e.g. textile, but the orientation of the first thermocouple legs 11 and/or second thermocouple legs 12 may also be different, e.g. substantially different from a direction orthogonal to the plane of the flexible material, and they need not be substantially parallel.

Within a thermocouple 10, the first thermocouple leg 11 and the second thermocouple leg 12 are connected at a first end 11 a, 12a by a first electrically conductive element 92. The first electrically conductive element 92 forms a low-resistance ohmic contact to the first thermocouple leg 11 and the second thermocouple leg 12, thus forming a junction between both legs 11, 12. In the example shown in FIG. 1, the first electrically conductive element 92 is also thermally conductive and functions as a flexible radiator element 90. The radiator element 90 in this embodiment is a flexible, wire-shaped element improving a heat flow through the thermocouple 10 when a temperature difference is applied between a first side 122 and a second side 123 of the flexible structure 121, e.g. when the thermoelectric generator 40 is provided between a heat source (e.g. a human body 61) located at the second side 123 of the flexible structure 121, and a heat sink (e.g. ambient air) located at the first side 122 of the flexible structure 121. In the example shown in FIG. 1, each thermocouple 10 comprises its own radiator 90, but that is not absolutely required, as will be described further.

First thermocouple legs 11 and second thermocouple legs 12 of different (e.g. neighbouring) thermocouples 10 are electrically connected to one another at a second end 10b of the thermocouple 10 opposite to the first end 10a where the first electrically conductive element 92 is provided, by a second electrically conductive element 91 such that a thermopile is formed, the thermopile comprising a plurality of thermocouples 10 electrically connected in series. In embodiments of the present invention the plurality of thermocouples 10 may also be connected electrically in parallel, or a combination of series connection and parallel connection may also be used. This may lead to an increased reliability of the TEG, because in case of damage to a part of the TEG the other, non-damaged, parts may still generate electrical power.

In the example shown in FIG. 1, the first end 11 a, 12a of the thermocouple legs 11, 12 is oriented towards a first side 122 of the flexible structure, e.g. textile 121, e.g. oriented towards a heat sink, such as the ambient environment 130, and the second end 11 b, 12b of the thermocouple legs 11, 12 is oriented towards a second side 123 of the flexible structure, e.g. textile 121, e.g. oriented towards a heat source, such as a human body 61. In the embodiment shown in FIG. 1, neighbouring thermocouples 10 are not thermally connected to each other, although in other embodiments of the thermoelectric system according to the present invention they may be thermally connected to each other. In this example, the first electrically conductive element 92, oriented towards the heat sink, also functions as a radiator element 90. This element 90 is further in particular embodiments referred to as radiator wire 90, although its shape can in general be different from a wire shape. For example, the radiator element 90 may have a film shape or a sheet shape. The radiator element may have any suitable length and thickness and cross section.

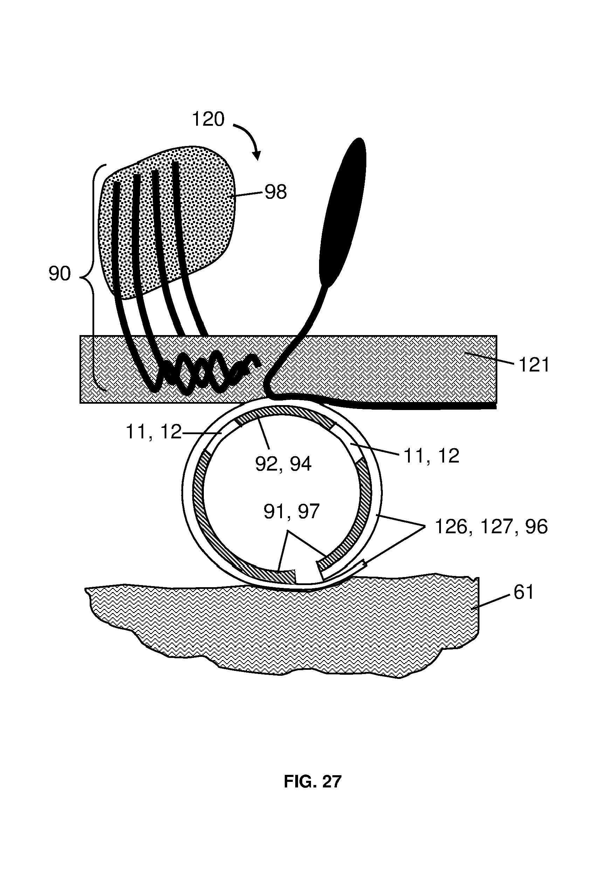

In the embodiment illustrated in FIG. 1, the radiator wire 90 performs different functions simultaneously: it electrically connects neighbouring thermocouple legs 11, 12 at a first end 11 a, 12a so as to form a thermocouple 10; it acts as a thermal radiator, i.e. it improves heat dissipation through convection, conduction and/or radiation (and, if wet, through evaporation) into a surrounding fluid such as air; and it may also provide thermal shunting of the flexible structure e.g. textile 121 for improving heat spreading in the flexible structure, e.g. textile, as will be discussed further with respect to FIG. 27. The radiator wire 90 has a longitudinal direction that is oriented substantially out of the plane of the textile 121. In the examples shown in the drawings the longitudinal direction of the radiator wire 90 is oriented close to an orthogonal orientation with respect to the plane of the flexible structure, e.g. textile 121. However, the present invention is not limited thereto and the longitudinal direction of the radiator wire 90 may be oriented differently with respect to the plane of the flexible structure, e.g. textile 121, for example it may be inclined or it may be in a plane substantially parallel to the plane of the flexible structure, e.g. textile 121. The radiator wire 90 being flexible, the orientation of the radiator wire 90 may change in time, e.g. during use of the thermoelectric system, e.g. the TEG 40.

The flexible radiator element 90 can also comprise a thermally insulating material in addition to a thermally conductive material. It can for example comprise at least two layers or foils, e.g. at least one layer or foil comprising a thermally insulating material such as a polymer, e.g. for providing mechanical support and flexibility, and at least one layer or foil comprising a thermally conductive material such as a metal.

The flexible structure, e.g. textile 121, with the integrated TEG 40 can for example be used in garments, wherein the second side 123 faces a body 61 of a human being or an animal, the body 61 acting as a heat source, and wherein the radiator wires 90 are oriented towards the environment, e.g. ambient air, acting as a heat sink. Second electrically conductive elements 91 are electrically conductive and may also be thermally conductive. In embodiments wherein second elements 91 are thermally conductive, this may lead to an improved thermal contact to the heat source, e.g. to (the skin of) a human body 61, and to a reduction of the thermal resistance between the body 61 and the thermocouples 10. For example, the second electrically conductive elements 91 can collect heat from the body 61 and transfer the heat to the thermocouple legs 11, 12. The heat passes through the legs 11,12 into radiator wires 90 and dissipates into the ambient 130. The heat flow between the body 61 (heat source) and the ambient 130 (heat sink) is converted into electrical power by the TEG 40.

For reaching a good power generation when the TEG 40 operates with a heat source and/or a heat sink having a high thermal resistance, preferably the TEG 40 is thermally matched to the heat source (e.g. human body) and the heat sink (e.g. ambient air) according to EP 1 970 973. The equations for optimization of such a wearable TEG differ from those commonly used because of the high thermal resistance of the environment in case e.g. a human body 61 is used as a heat source and e.g. ambient air is used as a heat sink. The maximum power, $P_{max}$, generated by a thermally optimized TEG, in its simplest form, with one thermocouple 10 per unit 120, is:

$$P_{max} = Z\Delta T_{tc,\,opt}\, \Delta T/8 R_{th,\,env,} \qquad\qquad (1)$$

where $Z$ is the thermoelectric figure-of-merit, $\Delta T_{tc,\,opt}$ is the temperature difference between the first end 10a and the second end 10b of the thermocouple 10 corresponding to the power maximum, $\Delta T$ is the temperature difference between the heat source (the body core temperature, which it is typically about 37°C in case of a human being) and the heat sink (the ambient air), and $R_{th,\,env}$ is the joint thermal resistance of the heat source (human body), the heat sink (ambient air), the second conductive element 91, and the radiator wire 90. The optimal temperature difference $\Delta T_{tc,\,opt}$ equals to:

$$\Delta T_{tc,\,opt} = \Delta T/(2(1 + R_{th,\,env}/R_{th,\,em})), \qquad\qquad (2)$$

where $R_{th,\,em}$ is the thermal resistance of an "empty" unit 120, which would be observed if the thermal conductivity of thermoelectric materials was equal to the one of textile (in this particular embodiment). This optimal temperature difference does not depend on the properties of the thermopile. Therefore, the thermal design of both the TEG 40 and its interfaces with the heat source and heat sink are important for reaching a good power output. The following equation of thermal matching allows reaching the power maximum:

$$R_{tu,\,opt} = R_{th,\,env}\, R_{th,\,em} /(2R_{th,\,env} + R_{th,\,em}), \qquad\qquad (3)$$

where $R_{tu,\,opt}$ is the optimal thermal resistance of the thermocouple unit. The optimal thermal resistance of a thermocouple inside a TEG, $R_{tc,\,opt}$, can be obtained as:

$$R_{tc, opt} = R_p R_{tu, opt}/(R_p - R_{tu, opt}), \tag{4}$$

where $R_p$ is the parasitic thermal resistance in the thermocouple unit 120 observed in parallel to the thermocouple 10.

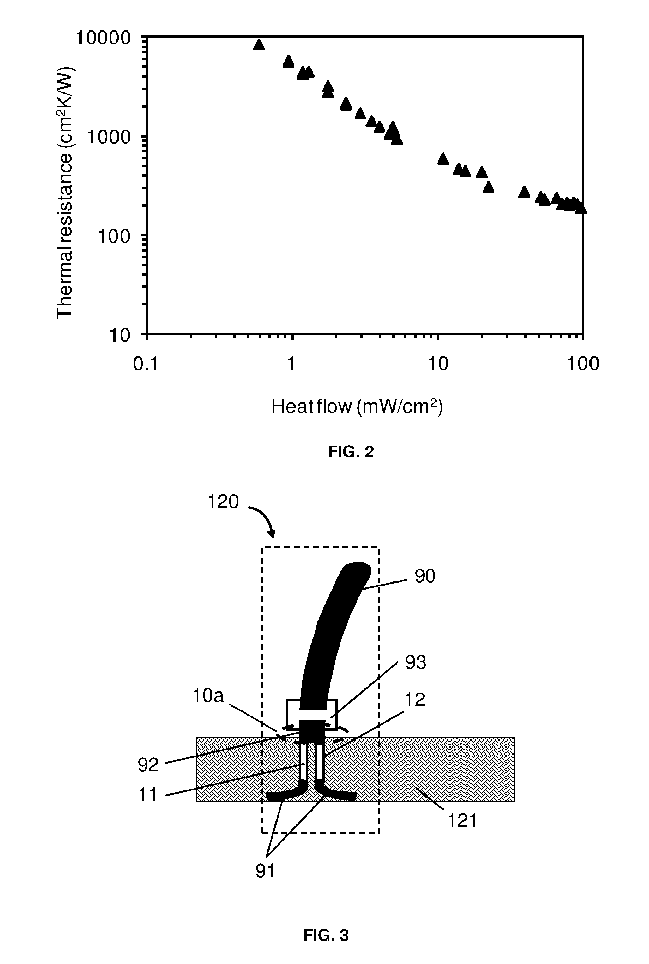

The size of the radiator wires 90 in their longitudinal direction can for example be in the range between 1 cm and 5 cm, but other suitable sizes may also be used. The radiator wires 90 decrease the thermal resistance of the body 61 through increasing the heat flow per unit surface of the body. The mechanism of this effect quantitatively studied on the front side of a leg of a person sitting indoors is shown in FIG. 2. FIG. 2 shows an example of a measurement of the thermal resistance of a human body 61 as a function of heat flow, measured on a leg, about 25 cm above the knee. At typical indoor conditions, the natural heat flow on a human skin is much less than 10 mW/cm$^2$. For example, on the leg of a person, it can be about 3 mW/cm$^2$. An increase of the heat flow by a factor of two decreases the thermal resistance of the body by a factor of two and allows a significant improvement in the power generated by a TEG, e.g. by about a factor of two. Also, the increased heat flow itself causes a proportional rise of the generated power, because the power is equal to the thermoelectric conversion efficiency (Z $\Delta$T/4) multiplied by the heat flow.

Referring back to Fig 1, the radiator wire 90 can comprise or can be made of a thermally conductive material such as a metal, or it can comprise two or more metal wires or metal layers. For example, a first wire made of steel or brass can provide mechanical support and flexibility, while a second, parallel wire or a layer, made e.g. of copper or aluminum, can provide low thermal resistance. The radiator wire 90 can also comprise a thermally insulating material, e.g., a polymer, coated with a thermally conductive material, e.g., a metal. Such a polymer can for example provide mechanical support and flexibility. Or, at least two layers or foils can be used, at least one layer or foil being thermally insulating, e.g. comprising a polymer, and at least one layer or foil being thermally conductive, e.g. comprising a metal. The at least two layers or foils can be attached or glued or laminated to each other or a first layer or foil can be coated or painted onto a second layer or foil. The radiator wire 90 comprising at least a thermally conductive material can also be coated with thermally and/or electrically insulating material such as paint, a dielectric, or a polymer.

Although the TEG 40 shown in FIG. 1 is described above for an embodiment wherein the flexible element or flexible structure is textile, and wherein the TEG is intended to be used with e.g. a human body as a heat source, a TEG as shown in FIG. 1 can also be used with other bendable or flexible layers such as for example glass fabric, foam sheets, polymer layers, plastic tubes, and it can be used with other heat sources, such as for example a heated machine.

When a TEG 40 as e.g. illustrated in FIG.1, is for example integrated with a flexible structure such as textile 121 and worn on a human body 61, the user can occasionally push the radiator wires 90 tightly towards the textile 121. In this case, the radiator wires 90 of different thermocouples 10 may touch each other, resulting in electrical shunting of these thermocouples 10. This would lower the voltage output of the thermopile, and thus the electrical power produced. To prevent electrical shunting, the radiator wires 90 can be coated with an electrically insulating material as described above. Alternatively, to prevent electrical shunting of the radiator wires 90, a first electrically conductive element 92 as illustrated in FIG. 3 can be provided for electrically connecting a first thermocouple leg 11 and a second thermocouple leg 12 within a thermocouple 10 at its first end 10a. The first electrically conductive element 92 is electrically insulated from but thermally connected to the corresponding radiator wire 90. Electrical insulation between the first electrically conductive element 92 and the corresponding radiator wire 90 can for example be obtained by providing an electrically insulating joint 93 in between the first electrically conductive element 92 and the radiator wire 90, as illustrated in FIG. 3. The insulating joint 93 can be made of any electrically insulating material, such as e.g. a polymer.

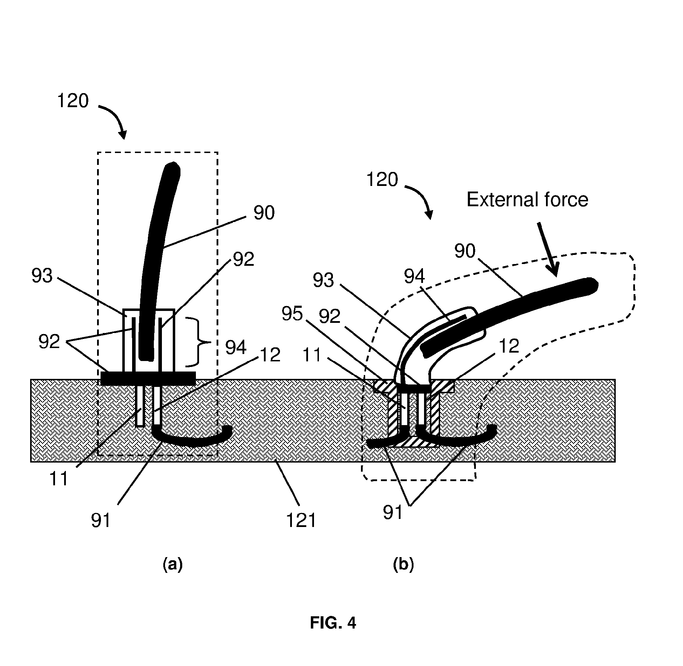

In case of low thermal conductivity of the material forming the electrically insulating joint 93, the thermal resistance between the first electrically conductive element 92 and the radiator wire 90 can be decreased by shaping and arranging the first electrically conductive element 92 such that at least part thereof is provided in parallel with the radiator wire 90 along a longitudinal direction of the radiator wire 90, e.g. surrounding the radiator wire 90, in a zone 94 as for example illustrated in FIG. 4(a) and FIG. 4(b). In this zone 94, the first electrically conductive element 92 can be thinner than the radiator wire 90 and, e.g., wound around the radiator wire (with a thin layer of electrical insulation 93 provided by joint material in between the radiator wire 90 and the first electrically conductive element 92), thereby providing mechanical flexibility to the joint 93.

Bending of a radiator wire 90 can lead to undesired forces on the thermocouple legs 11, 12. If the thermocouple legs are not flexible, or too fragile, a flexible joint 93 can be provided as shown in FIG. 4(a) and FIG. 4(b). Further protection of the thermocouple legs 11,12 from external forces and shocks can be provided, for example by providing a thermally insulating reinforcing structure 95 of any appropriate shape, such as for example the stiffness enhancement structure 95 shown in FIG. 4(b), e.g. surrounding the thermocouple legs 11, 12. The part of the first electrically conductive element 92 in the zone 94 surrounding the joint 93 can be made of a foil or a metal film, thereby providing good flexibility to the joint 93.

Forces affecting the thermocouple legs 11,12 through a radiator wire 90 can be further reduced by fabrication of the radiator wire 90 from glass, polymers, or any other suitable material, preferably with a lower Young's modulus than that of the material of the thermocouple legs 11, 12. For maintaining the required thermal conductance, a layer of thermally conductive material can be deposited on such a radiator wire 90.

In embodiments wherein the radiator wire 90 comprises a thermally conductive foil or wire, coated with an electrically insulating material, decoupling of the first electrically conductive element 92 from the corresponding radiator wire 90 as shown in FIG. 3 may be no longer needed for avoiding electrical shunting of thermocouples 10.

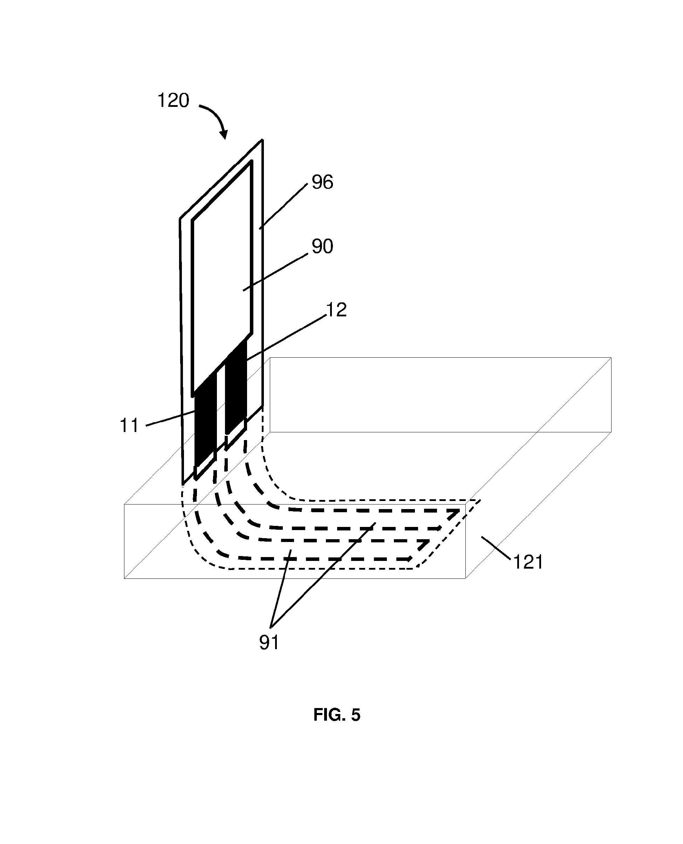

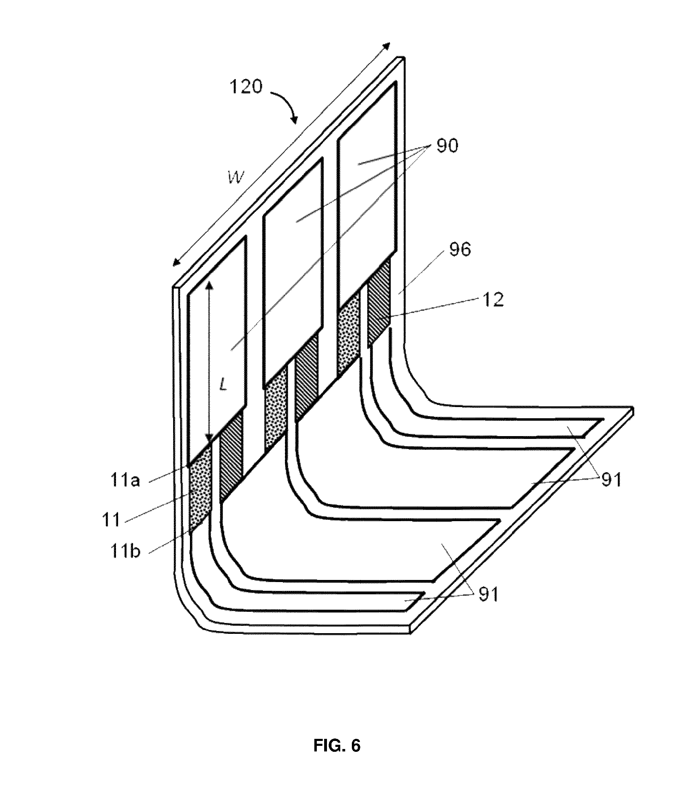

In a thermoelectric system according to embodiments of the present invention the thermocouples 10 and/or thermocouple units 120 can for example be fabricated on a tape such as for example a polymer tape 96 as illustrated in FIG. 5, FIG. 6 and FIG. 7. The tape 96 is preferably made of a material that is electrically insulating and thermally insulating. One or more than one thermocouples 10 can be provided in one thermocouple unit 120, as illustrated in FIG. 6. In the embodiments shown in FIG. 5, FIG. 6 and FIG. 7 the radiator element 90 has a film shape. The radiator element may be flat and may have any suitable shape, such as for example rectangular, square, circular, oval or any other suitable regular or irregular shape.

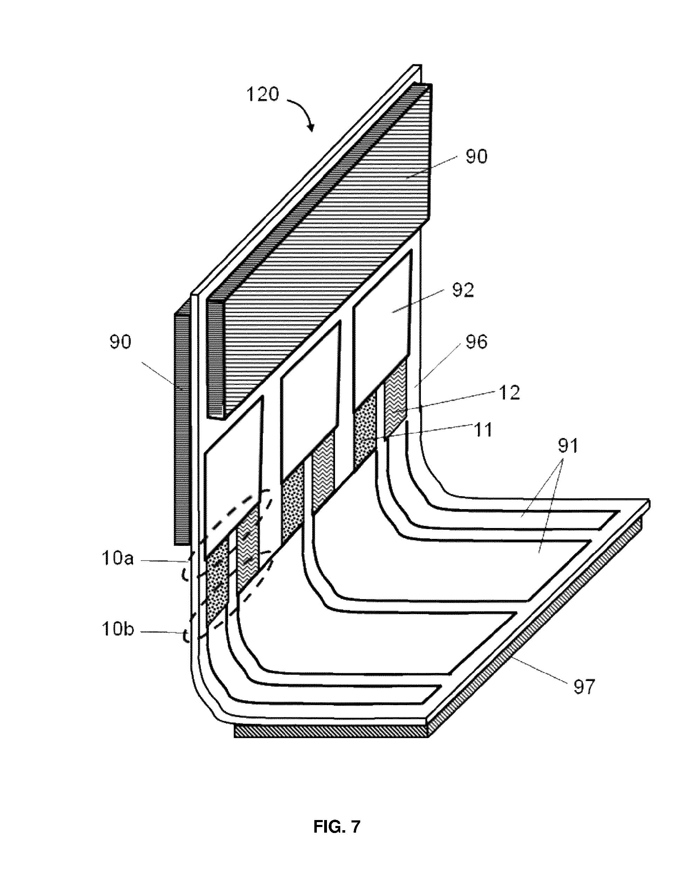

The thermally conductive radiator element 90 may for example comprise a thermally conductive film, such as a metal film. The thermally conductive film, e.g. metal film, may be coated on one or both of its major surfaces with an electrically insulating material such as a polymer. Coating the thermally conductive film, e.g. metal film, on both surfaces with an electrically insulating layer such as e.g. a polymer allows avoiding electrical shunting between radiator elements 90 in case of bending of the radiator elements 90. Therefore, in such embodiments the need for electrical decoupling between an electrical connection 92 and a radiator element 90 may be avoided. However, in practical situations, the flexible structure, e.g. textile 121, may be wet. Therefore, electrical decoupling between the radiator element 90 and first electrically conductive elements 92 may still be preferred. An exemplary embodiment with such electrical decoupling is illustrated in FIG. 7.

As an example, in a wearable device, the length $L$ of the film-shaped radiator element 90 in longitudinal direction, as for example illustrated in FIG. 6, can e.g. be in the range between 2 cm and 5 cm, at a thickness of 0.2 mm to 0.4 mm and a tape width $W$ of 1 mm to 4 mm. However, other suitable dimensions and thicknesses may also be used.

In the embodiment shown in FIG. 7 a thermal shunt 97 consisting of a thin layer of highly thermally conductive material, e.g. a metal film, is provided at the "hot side", i.e. the side closest to the second end 10b of the thermocouple 10. This layer of thermally conductive material spreads the heat from contact areas with the heat source (e.g. contact areas with the skin when the heat source is a human body), leading to a decreased thermal resistance across the polymer tape 96 due to a uniformly heated underlying metal.

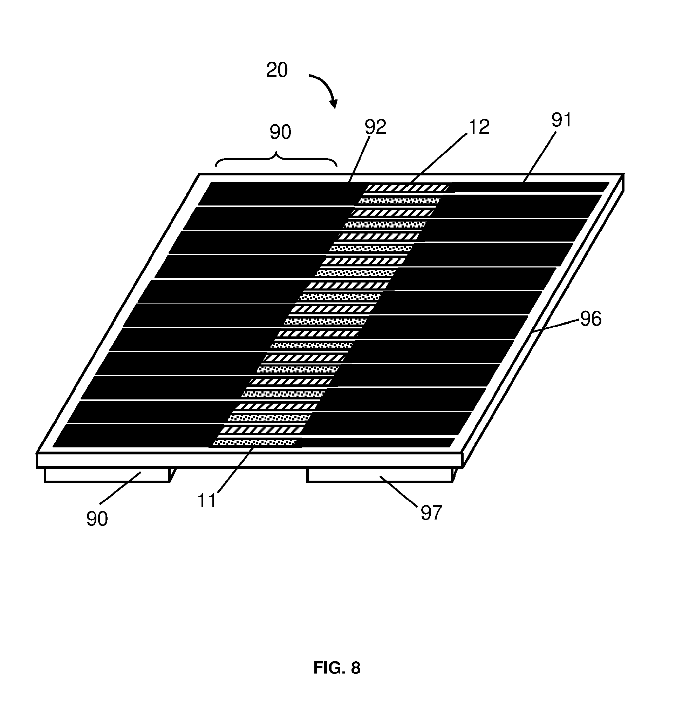

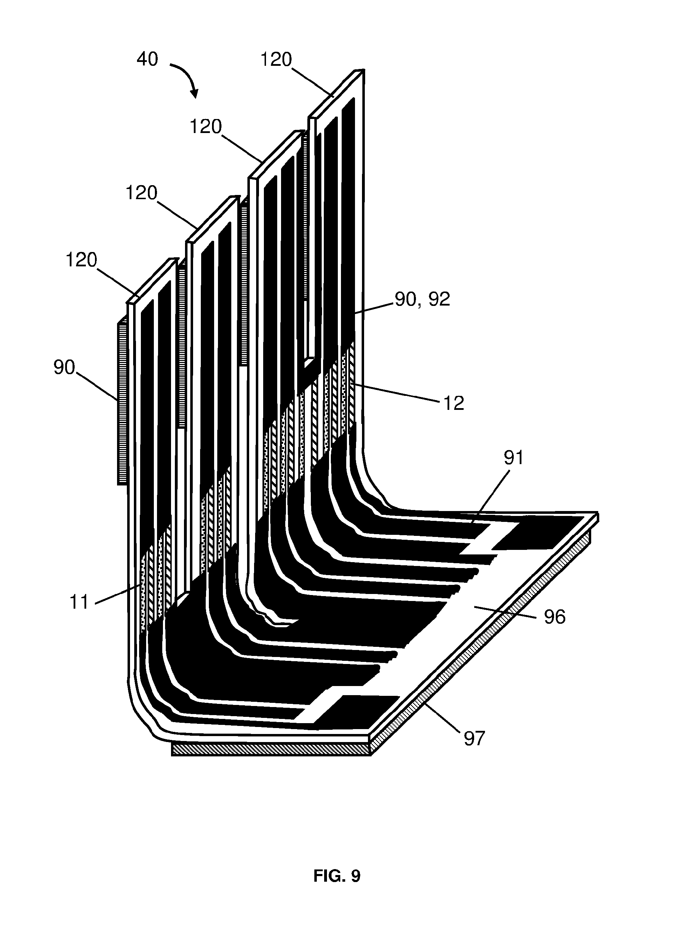

FIG. 8, FIG. 9 and FIG. 10 illustrate steps of an exemplary fabrication process for a film-based thermoelectric generator comprising a plurality of thermocouple units 120. As illustrated in FIG. 8, first thermocouple legs 11, second thermocouple legs 12, first electrically conductive elements 92 and second electrically conductive elements 91 are provided on an electrically and thermally insulating tape, e.g. polymer tape 96, and they may be coated/sealed by another tape (not illustrated). A thermally conductive film, e.g. metal film, for forming radiator elements 90 is provided on one or both major outer surfaces of the tape 96 at a first end 11 a, 12a (e.g. cold side) of the thermocouple legs 11, 12. A metal film deposited at a second end 11 b, 12b (e.g. hot side) of the thermocouple legs 11, 12 may act as a hot-side thermal shunt 97, improving heat transfer from a heat source to the hot junctions 11 b, 12b of the thermocouples 10. Next, the structure shown in FIG. 8 is bent and thermocouple units 120, acting as thermopile units, each comprising one or more thermocouples 10 are formed as illustrated in FIG. 9.

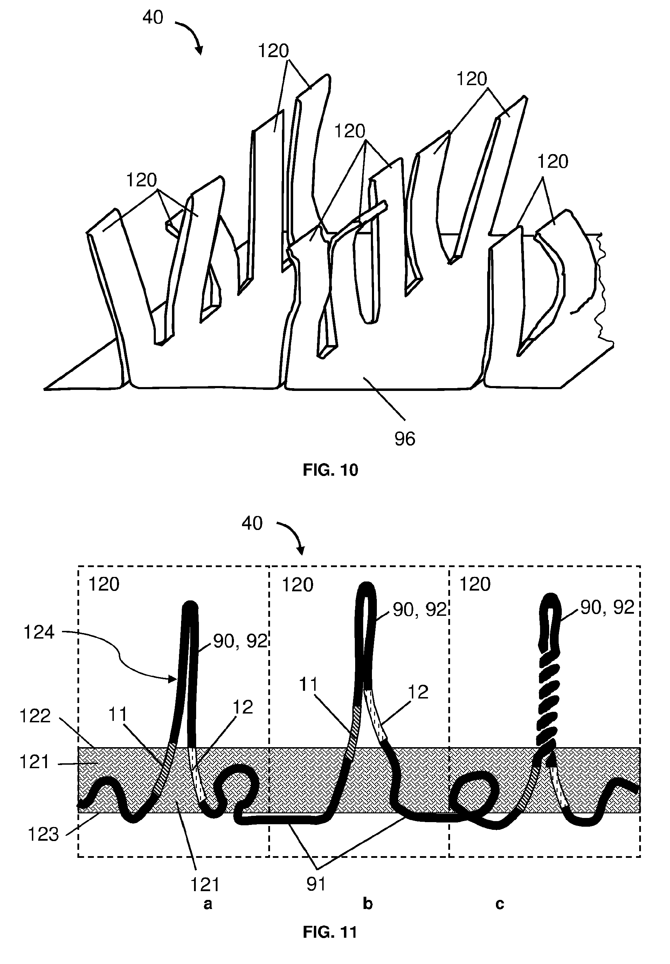

Fabrication of a plurality of thermocouple units 120 on one carrier tape 96 is advantageous because it simplifies integration of the thermocouple units 120 with a bendable or flexible structure 121, such as textile. It is an advantage when second electrically conductive elements 91 between thermocouples 10 and between thermocouple units 120 are already provided on the tape 96. Typically, several thousands of thermocouples 10 may be required in a wearable thermoelectric generator (TEG) to provide an output voltage of about 1 V, or higher. Therefore, a TEG 40 according to embodiments of the present invention may comprise a tape 96 with a total area of for example about 3 cm to 5 cm width and 10 cm to 30 cm length, with partial separation of thermocouple units 120 from each other as illustrated in FIG. 9. If more electrical power is required for a wearable device, the integrated TEG 40 may comprise a plurality of thermopile tapes, wherein the thermopile tapes can be connected electrically in series and/or in parallel. Parallel connection may provide more reliable thermoelectric systems in case of failure of one of the thermopile tapes. Also, one tape comprising a plurality of rows of thermocouple units 120 can be integrated into a flexible structure such as textile 121, e.g., in a way as schematically illustrated in FIG. 10.

In accordance with embodiments of the present invention, a thermoelectric system and/or thermoelectric generator system comprising thermocouple units 120 may also be fabricated by direct weaving of a thermoelectric wire 124 into textile, as illustrated in FIG. 11. The thermoelectric wire 124 comprises an alternating pattern of different elements in the following sequence, the elements being electrically connected together in series: (1) a second electrically conductive element 91; (2) a first thermocouple leg 11; (3) a radiator wire 90, also functioning as a first electrically conductive element 92; and (4) a second thermocouple leg 12. In such a thermoelectric wire 124, the elements (1) to (4) are repeated a plurality of times, e.g. tens, hundreds or thousands of times. As shown in FIG. 11, the weaving should be done such that the first electrically conductive elements 92 are arranged on a first side 122 of the flexible structure 121, and the second electrically conductive elements 91 are arranged at the second side 123 of the flexible structure 121, or vice versa. The second electrically conductive elements 91 can also perform the function of a thermal shunt 97, e.g. for improving the heat spreading between two adjacent thermocouples 10. The second electrically conductive element 91, e.g. metal interconnect 91, can be woven into the textile 121 as illustrated in FIG. 11(a), or it can be provided on a surface of the textile as shown in FIG. 11(b). The thermocouple legs 11, 12 can be embedded in the textile 121 as shown in FIG. 11(a) and FIG. 11(c), or they can be located outside the textile 121 as shown in FIG. 11(b), on an outer side 122 of the textile 121 (i.e. the side oriented towards the heat sink, e.g. ambient air). The radiator wire 90 is provided at the outer side of the textile 121.

In case of a wearable device, it is preferably avoided that the radiator wires 90 are shaped as an open loop (as e.g. shown in FIG. 11(a)), because the user may easily break such a loop, occasionally caught by surrounding objects. Therefore, the two parts of the radiator wire 90, one going out of the textile 121, and the other going back into the textile 121, are preferably connected to each other by using any suitable method such as welding, hot pressing, gluing, crimping, twisting or winding these two parts into one "thread" as shown in FIG. 11(c). The radiator wire 90 or the thermoelectric wire 124 acting as radiator element can have an electrically insulating coating. The radiator wire 90 can be made of foils or can comprise different layers. The thermoelectric wire 90 can also be sandwiched between two substrates or two layers of insulating materials so as to be encapsulated.

For maximum power generation, the TEG 40 preferably follows or at least approaches the thermal matching conditions according to EP 1 970 973. However, an integrated thermoelectric generator system as described above produces higher voltage and power as compared to known prior art TEGs in any textile-integrated devices, i.e. even if not following the thermal matching conditions. This is related to a decreased thermal resistance of the heat source (e.g. body 61) caused by the radiator wires 90 and optionally the thermal shunt 97, to an increased heat flow, and to a decreased thermal resistance of the ambient, e.g. air, due to the presence of radiator wires 90.

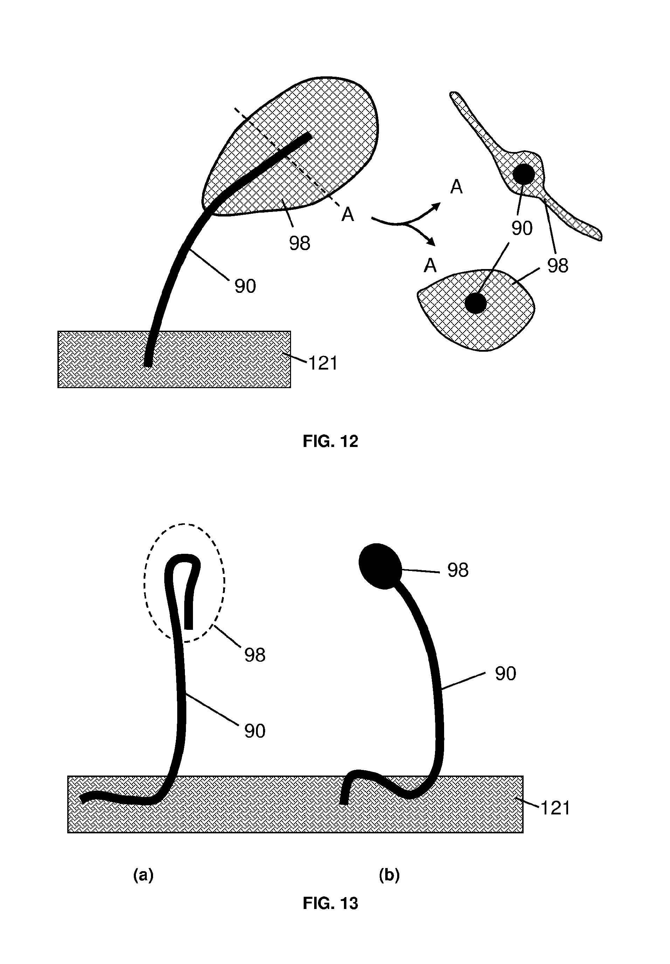

For further improving the heat transfer from the radiator wires 90 to the ambient, the radiator wires 90 may have an area enlargement element 98. The area enlargement element can be made of a thermally conductive material or it can comprise two or more wires or layers, of which at least one is thermally conductive e.g. at least one metal wire or metal layer. An example of such an area enlargement element 98 is illustrated in FIG. 12, where the area enlargement element 98 has a 2-dimensional shape resembling a leave of a tree. The area enlargement element 98 can also have any other suitable shape, such as for example a 3-dimensional shape such as e.g. a ball shape. The area enlargement elements 98 can be made of polymer, metal, metal foil, paint, solder. It can also be made from the material of the radiator wire 90, for example by mechanically flattening an end portion of the wire 90, or by bending the radiator wire 90 (FIG. 13(a)), or by making a ball-like ending of the radiator wire 90 (FIG. 13(b)). Such area enlargement elements 98 may also protect the wearer of the TEGs from harmful (e.g. sharp) ends of wires 90.

Typically, the flexible structure, e.g. textile 121, touches the heat source (e.g. the skin) only partially. However, physical disconnection of second electrically conductive elements 91 from the heat source causes a high thermal resistance that is added in series with that of the thermocouples 10 and therefore dramatically decreases the produced electrical power. Therefore, flexible hot-side thermal shunts 97 may be successfully used to decrease the thermal resistance at the "hot side" of the flexible structure 121, e.g. to thermally connect the skin to conductive elements 91, as will be described next.

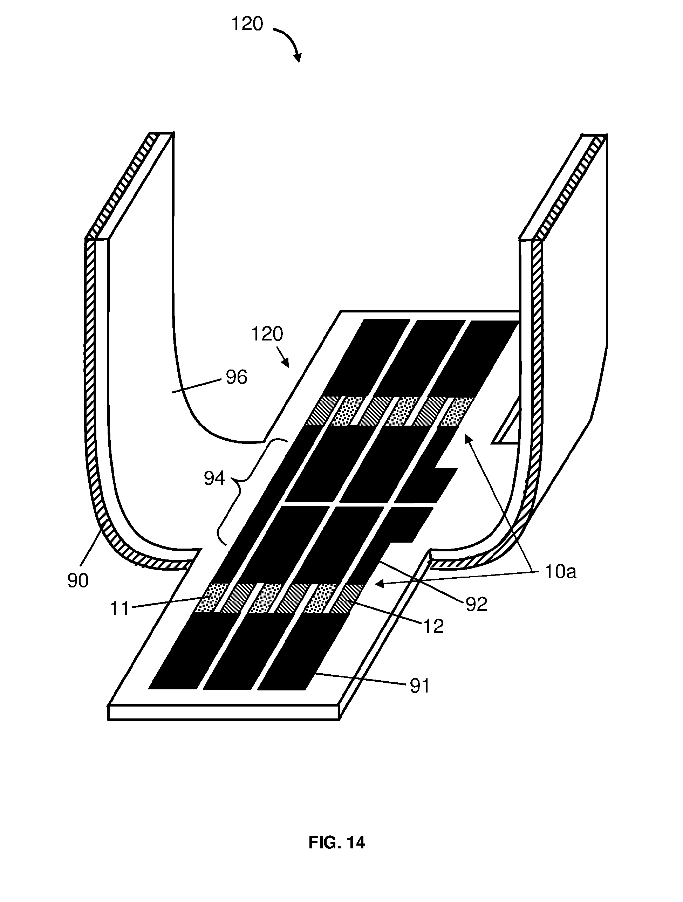

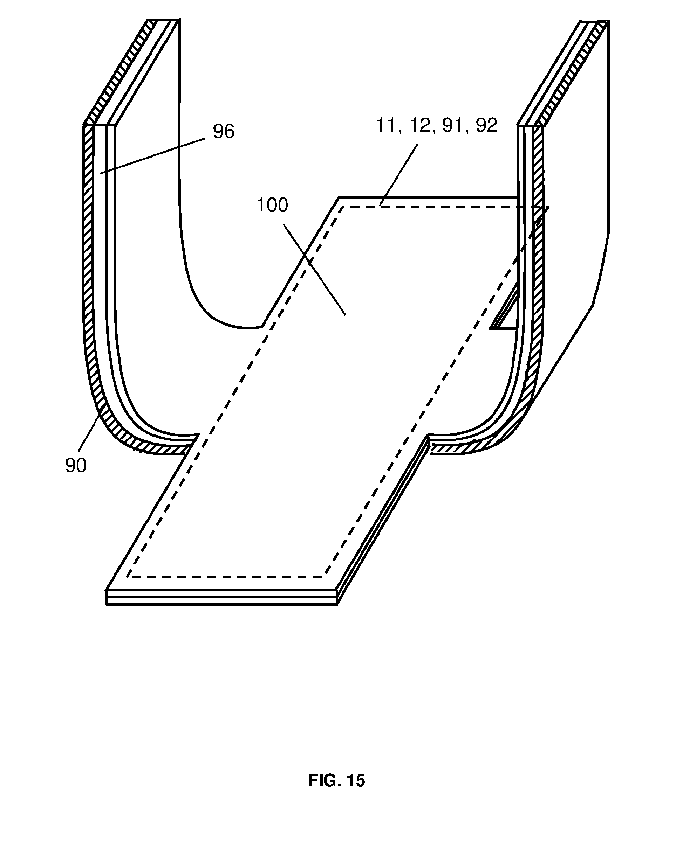

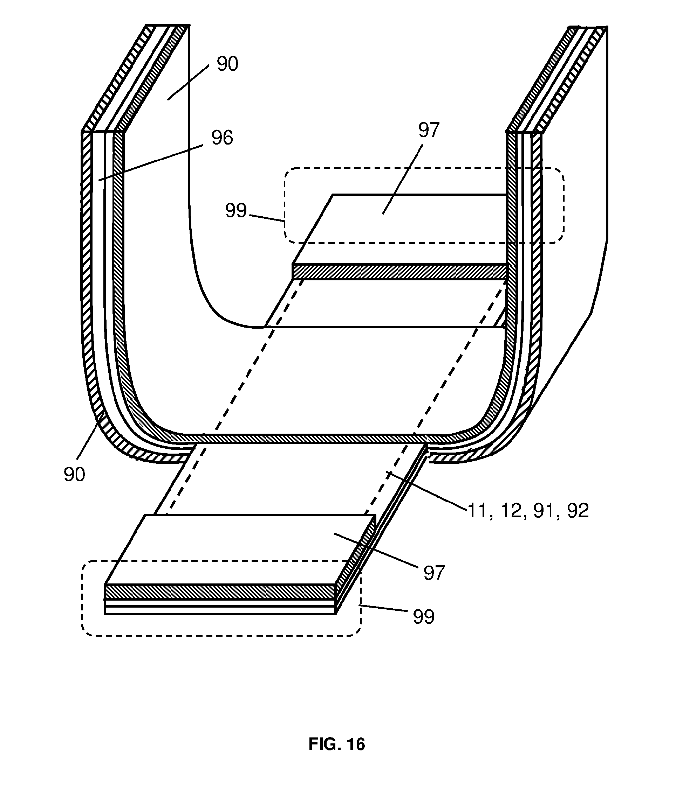

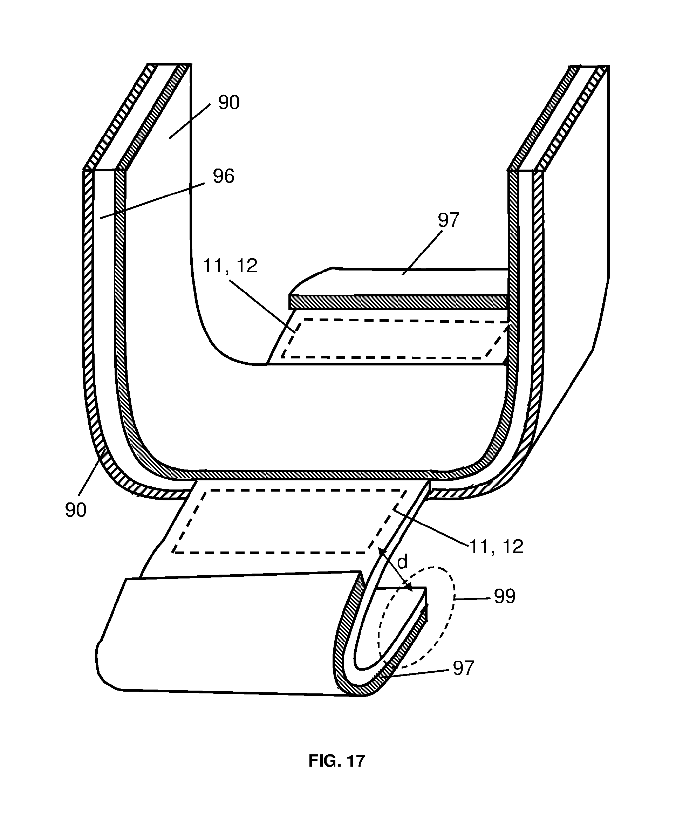

FIG. 14, FIG. 15, FIG. 16 and FIG. 17 illustrate steps of an exemplary method for fabricating a thermocouple unit 120 on an insulating tape 96, including a hot-side thermal shunt 97. FIG. 14 shows a thermocouple unit 120 fabricated on a polymer tape 96. The thermocouple unit 120 comprises two rows of thermocouples 10 with their cold ends 10a facing each other, and having two radiator elements 90. This thermocouple unit 120 is then coated with an electrically and thermally insulating layer or tape 100 such that it is sandwiched between the polymer tape 96 and the layer or tape 100 (FIG. 15). As illustrated in FIG. 16 such a structure offers an enlarged area for providing thermal shunts 97 at the hot sides of the thermocouple rows. When being integrated into a flexible structure, e.g. textile 121, or directly into garments, a part comprising the thermal shunt 97 is bent, e.g., as shown in FIG. 17. The free end 99 of the thermal shunt 97 may be located under the textile 121 (i.e. in between the textile 121 and the heat source, e.g. human body), while the remaining part of the TEG 40 may be located on an outer surface (oriented towards the heat sink, e.g. ambient air) of the textile 121. The zone with thermocouple legs 11,12 (FIG. 17) may be located under the textile 121, i.e., between the textile 121 and the heat source (e.g. body 61), or in the textile itself, or in between two layers of a textile, or on the outer surface of textile, or outside the textile, at a short distance 'd', e.g. 1 mm to 2 mm from the textile. Such a short distance 'd' between the zone with thermocouple legs and the textile can for example be obtained by providing spacers between the zone with thermocouples and the textile, or by appropriate bending of the polymer tape 96 (as illustrated in FIG. 17). The free end 99 is preferably not touching the textile 121, but bends towards the skin surface for at least a few mm to provide direct mechanical and thermal contact with the heat source, e.g. the skin. Preferably the distance 'd' between the thermocouple legs 11,12 and the free end 99 is at least a few mm in a direction orthogonal to the plane of the thermocouple legs 11, 12.

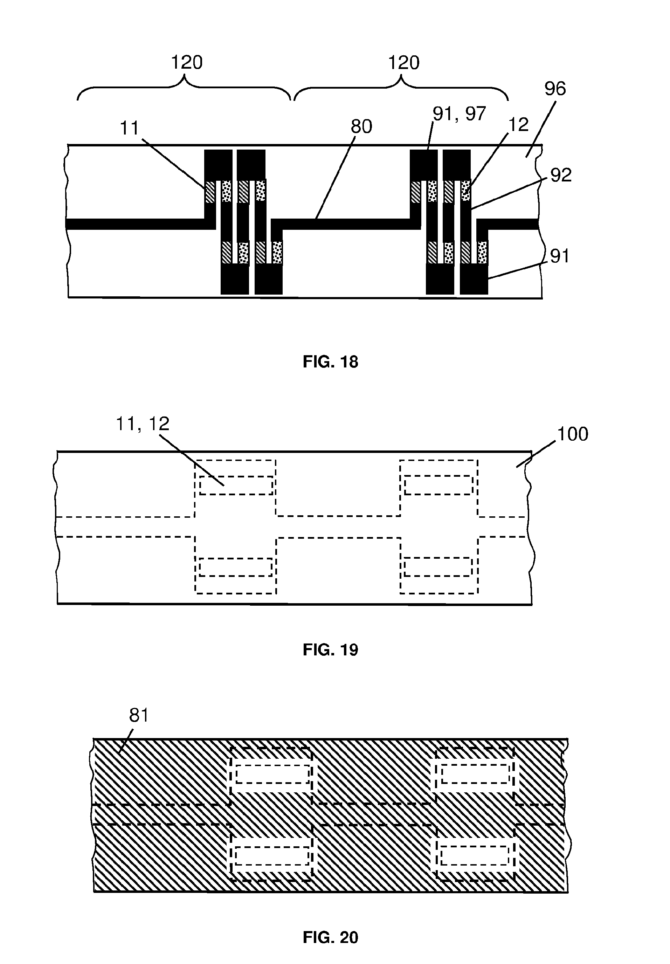

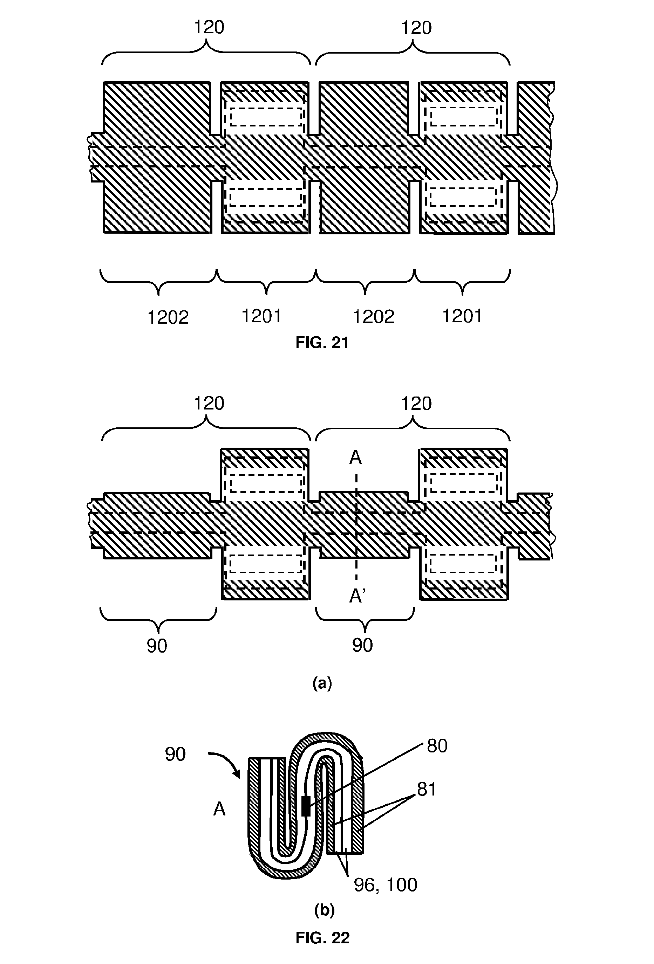

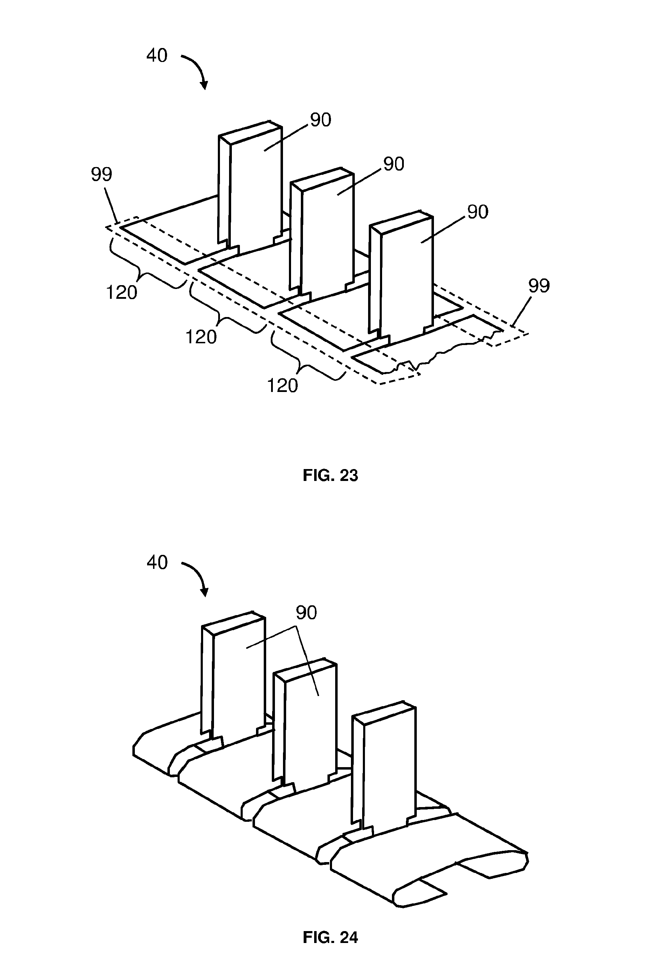

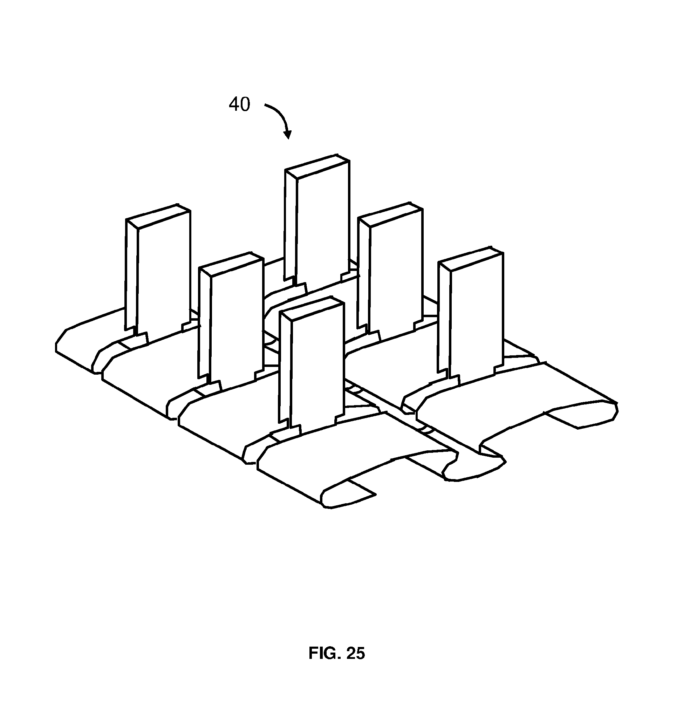

A particular example of steps of a fabrication process of a thermoelectric generator on an insulating roll-to-roll tape is illustrated in FIG. 18, FIG. 19, FIG. 20, FIG. 21, FIG. 22, FIG. 23, FIG. 24 and FIG. 25. In such a process the thermocouples 10 are fabricated on a roll-to-roll tape 96 with sequentially integrated thermocouple units 120 and with electrically conductive, e.g. metal, interconnects 80 between them (FIG. 18). The tape 96 is coated or attached to another layer of similar electrically and thermally insulating tape 100, such that the fabricated structures are encapsulated between the two tapes (FIG. 19). Next, the tape 100 is coated with a thermally conductive, e.g. metal, layer 81 by any known method, or attached to a thermally conductive, e.g. metal, foil, leaving openings in the zones comprising thermocouples 10. This is schematically illustrated in FIG. 20. This thermally conductive, e.g. metal, layer 81 is provided for improving heat transfer in the final device. Depending on the location of the thermally conductive, e.g. metal, layer 81 or foil in the final device, it can for example have the function of a radiator wire 90, thermal shunt 97 or a thermally shunting structure between the thermocouple 10 and the radiator element 90 (called "zone 94" above). In a next step the resulting structure is cut on cutting lines as shown in FIG.21, thereby creating alternating zones 1201 comprising thermocouples 10 and zones 1202 without thermocouples. The tape in the zones 1202 without thermocouples is then fold in a several-layer thick structure for forming a radiator element 90, as shown in FIG. 22(a) and (b). FIG. 22(b) is a cross section along line A-A' shown in FIG. 22(a). A 3D view of the resulting TEG 40 is shown in FIG. 23. When the TEG 40 is integrated into textile, the ends 99 of thermal shunts are bend, as shown in FIG. 24. In FIG. 18 to FIG. 24 a single row of thermocouple units 10 is shown. However, the TEG 40 can comprise multiple rows of thermocouple units 120. As an example, a TEG 40 with two adjacent rows of thermocouple units 120 is schematically shown in FIG. 25.

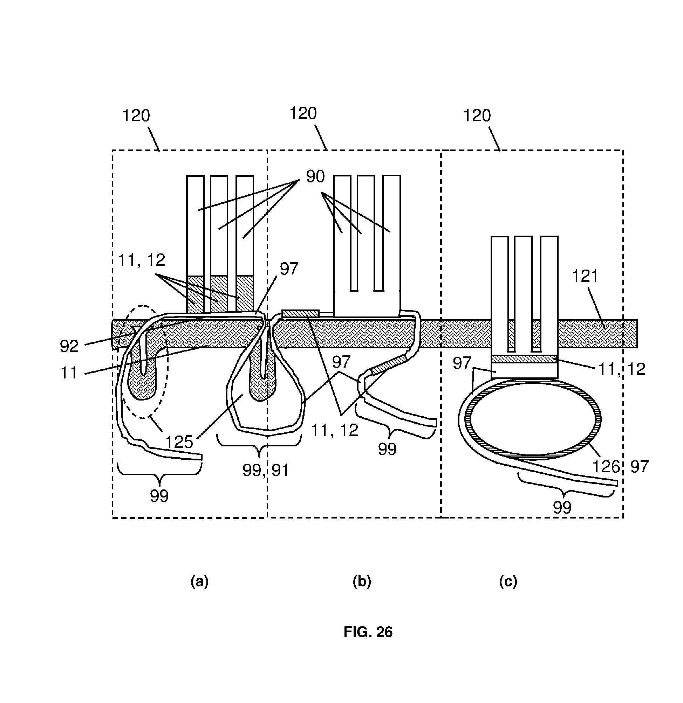

To further improve the thermal insulation of the cold side 10a of the thermocouples 10 from the heat source (e.g. the skin), thermally insulating spacers can be provided in between the heat source and the thermocouples. This helps to restrict the heat transfer via a path other than through the thermocouples 10. This can for example be done by a particular type of manufacturing the flexible structure 121, e.g. a particular type of weaving the textile, e.g. through formation of "walls" or bumps 125 in the textile 121, as illustrated in FIG. 26(a) (b). For further thermal insulation between the hot side 10b and cold side 10a of a thermocouple 10, additional thermally insulating structures such as a polymer layer, or a polymer foam may be provided to maintain an air gap between the flexible structure 121, e.g. textile, and the heat source (e.g. body 61), but allowing direct contact of thermal shunts 97, their free ends 99, and/or second electrically conductive elements 91 to the heat source. A good thermal insulation could be provided using a microporous or nanoporous material, especially with closed cells or pores. The pores may be filled with a gas with low thermal conductivity, or the pores may be provided with a reduced pressure or vacuum inside. Also, small-size gas-filled, e.g. air-filled, polymer structures such as for example small pads 126 filled with gas such as air may be used as illustrated in FIG. 26(c). The pads 126 can be thermally conductive to deliver all the collected heat to the hot side 10b of the thermocouples 10, or they can have a thermally conductive coating or patterned structures acting as a thermal shunt 97. An additional thermal shunt 97 can be provided, as shown in FIG. 26(c).

In alternative embodiments, the thermocouple units can also be fabricated on such a pad 126, or inside a pad, or between different layers of a pad 126.

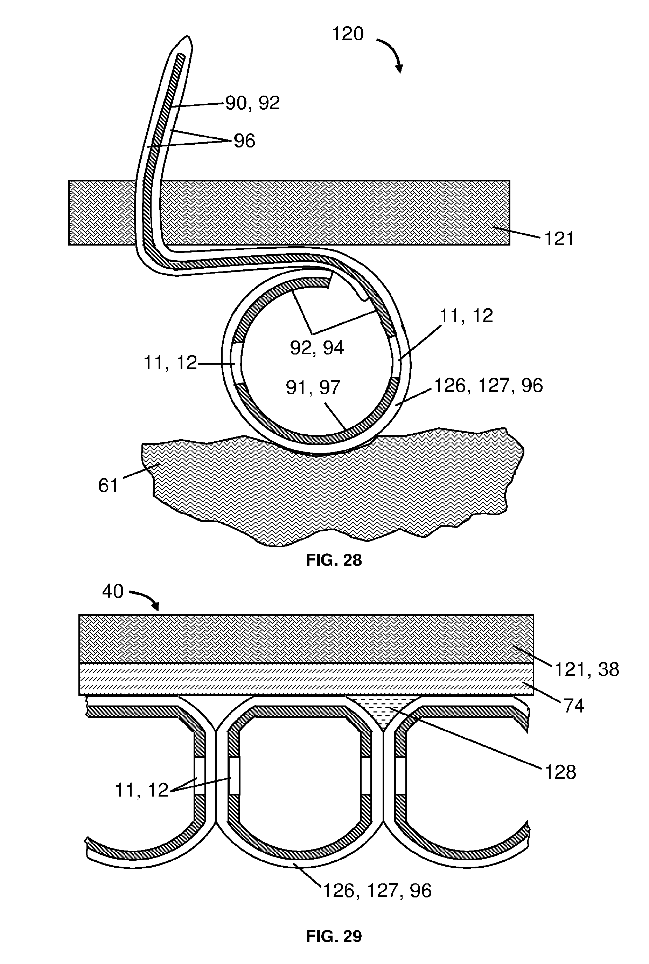

The thermocouple units can be also fabricated in or on a tube 127, e.g. a tube made of a thin polymer layer or tape 96. Examples of such a tube 127 are shown in FIG. 27 and FIG. 28. In FIG. 27 one tube 127 is shown in cross section, the tube 127 being thermally connected to separately fabricated radiator wires 90 through the flexible structure, e.g. textile 121. In FIG. 28, another example is shown, wherein the radiator wires 90 are fabricated on the same tape 96 as the tube 127. The tube may also be filled with a gas, preferably at a pressure slightly higher than atmospheric pressure to maintain the shape of the tube. To better keep the tube shape, it may also be filled with porous materials such as a cotton thread, nanoporous foam, gas-filled, e.g. air-filled, polymer micro-balls or any other material or structure that allows keeping the shape of the tube 127 and providing thermal insulation between the hot and cold sides 10a, 10b of the thermocouples 10.

The tubes 127, especially if they have a diameter of less than 1 mm, may be directly woven in the textile 121, or tightly connected to each other by gluing, welding, or processing multiple tubes next to each other in one technological process, e.g. forming a structure as shown in FIG. 29. As an example, a thermally conductive, e.g. metal, foil 74 (or a thermally conductive layer 74 of any shape, or a thermally conductive plate 74 of any shape) serving as a heat distributing element for better heat transfer to the flexible structure, e.g. textile 121, acting as a cold plate 38 is shown. The thermally conductive, e.g. metal, foil 74 also serves as a thermal shunt between the flexible structure, e.g. textile 121, and thermoelectric tubes 127. The tubes may be attached to the thermally conductive, e.g. metal, foil 74 by using thermally conductive glue or an epoxy 128. The flexible structure, e.g. textile 121, itself can serve as a cold plate. It may be physically attached to the thermal shunt 74, or it may just touch the thermal shunt 74.

Measurements have shown that a 0.8 mm-thick textile of jeans improved the electrical power generated by a TEG 40 with a black-coated shunt 74 by over 7%. This is based on experiments wherein a TEG module 40 with a size of 3 cm x 4 cm x 0.65 cm integrated in an opening in jeans was positioned on a leg, about 25 cm above the knee. The generated electrical power under these circumstances was used as a reference. Next the jeans material was removed and the TEG 40 was covered by the textile 121 comprising a shunt 74. The power measured under these circumstances was 7% higher as compared to the reference situation. This indicates that a higher heat flow was obtained when the TEG 40 was covered with a thermally insulating textile 121. This unexpected result is related to spreading of the heat in the textile 121 such that the effective radiating area increases and is larger than the 3 cm x 4 cm size of the TEG module that was used.

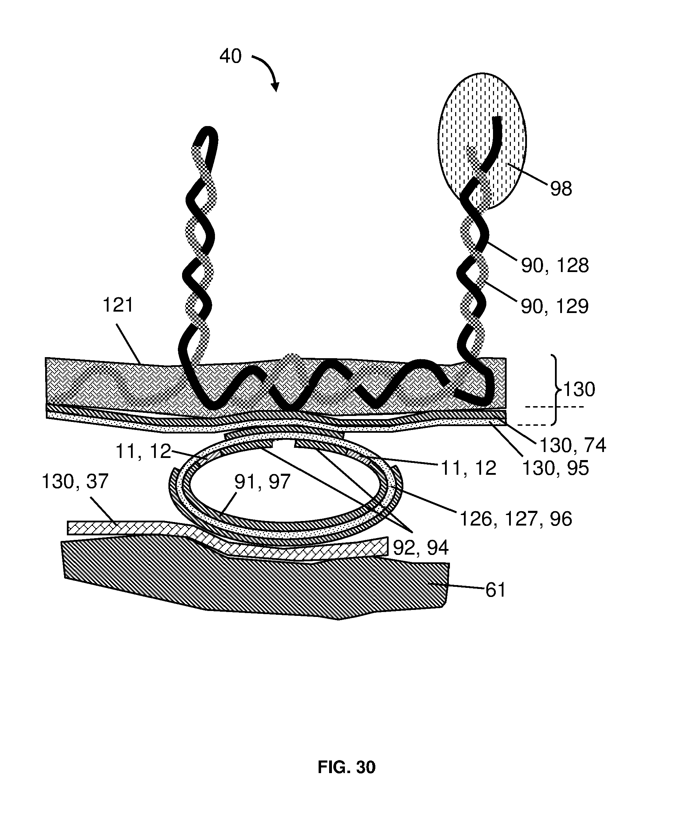

To avoid rotation of tubes 127 and for providing mechanical protection, protection layers 130 may be provided at the cold side and/or at the hot side of the TEG 40. The protection layers 130 can be made of any suitable material, but preferably of a thermally conductive material such that they may also effectively perform functions of a hot plate 37, e.g. a flexible hot plate and/or a cold plate 38, e.g. a flexible cold plate. An example is shown in FIG. 30, wherein the radiator wires 90 are woven in the textile and form a quasi-rigid protection grid or a net in the textile 120. A thin (flexible or rigid) protection layer 130 is attached to the TEG 40 from the hot side and touches the skin of the body 61. It can perform effectively the function of hot plate 37, as illustrated in FIG. 30. As a further example, an additional layer 130 can be added not only for mechanical protection, but also for providing improved heat spreading over an area of the textile 121 and for improving the thermal contact with the thermocouples 10.

The radiator elements 90 can be made of two materials like bi-metal foil or a co-axial wire, or two different metals deposited or attached to an insulating polymer layer, e.g. an insulating support or support substrate or a support tape. For example, a first metal wire 128 (FIG. 30) can provide stiffness and elasticity, and can be, e.g., steel or brass. A second metal wire 129 (FIG. 30) can provide heat conduction, e.g., it can comprise copper or aluminium. The first metal wire 128 can also be made of other stiff and elastic materials such as polymers or composites.

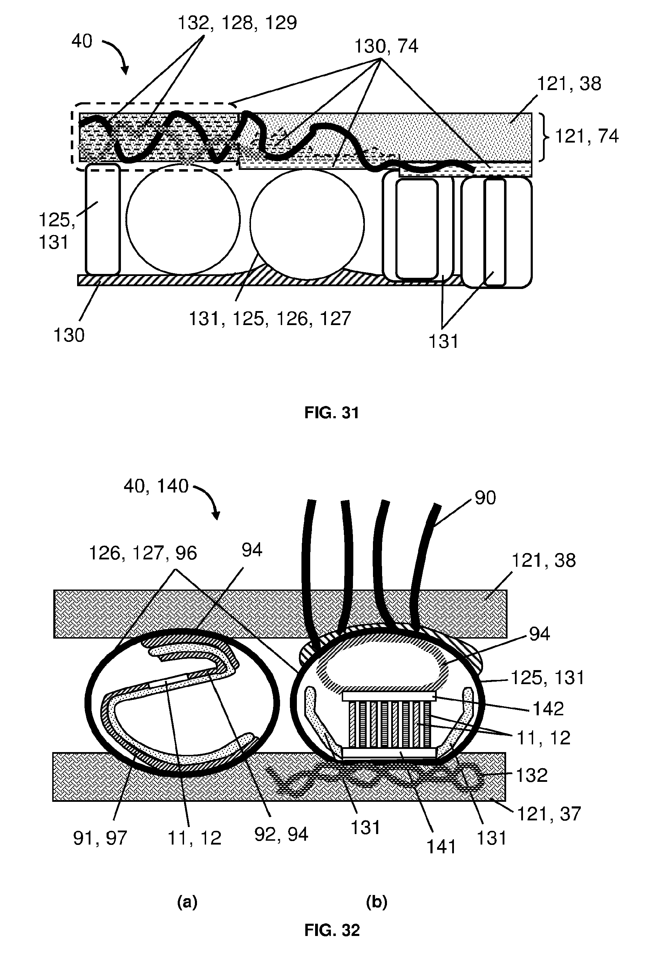

The cold plate 38 and/or the protection layer 130 may provide mostly protection from shocks and forces from the outer surface of the TEG 40, but may be less needed from the soft body side. Therefore, in case of a stiff cold plate 38 or stiff protection layer 130 on the outer surface of tubes 127, protection of thermocouples 10 from fattening or damaging could also be provided by using thermally insulating structures, e.g., walls 131, preferably stiff, or elastic, as shown in FIG. 31. They can be provided in combination with layers 130, or they can be located in the tubes 127, or fabricated as a part of a thermocouple, or as a part of other elements of the TEG 40. The protection layer 130 can also be a second layer of textile, or the same textile layer with polymer filling. The wires 128, 129 can be foil-based structures or film-based structures and can comprise strips. These can be woven in the textile, or can be provided as a separate web or net.

Also, the flexible structure, e.g. textile 121, itself can be used as a cold plate 38 as illustrated in FIG. 29 and FIG. 31. In such embodiments, the flexible structure, e.g. textile 121, preferably comprises thermally conductive wires 132, e.g. provided in the flexible structure, such as woven in the textile. Even with no added thermally conductive wires 132, the thermal conductivity of the flexible structure, e.g. textile, in the plane of the flexible structure, e.g. textile, is higher than in a direction orthogonal to the plane of the flexible structure, e.g. textile. This effect results in spread of the heat transferred from a thermocouple unit 120 to the flexible structure, e.g. textile 121, over an area larger than the contact area between the unit 120 and the flexible structure, e.g. textile 121. Therefore, the flexible structure, e.g. textile, starts to actively perform the function of cold plate 38. Still a complete or partial filling of the flexible structure, e.g. textile, with thermally conductive materials such as polymers, e.g. filled with thermally conductive particles, is preferable if it does not introduce discomfort to a person wearing such device. Such filling of the flexible structure, e.g. textile, can also create a protection layer 130, at least partly, in the flexible structure, e.g. textile, as also illustrated in FIG. 31. It can also be used for better thermal connection of thermocouples to the cold plate 38, flexible structure e.g. textile 121, and/or radiator wires 90.

The present invention is not limited by the particular structures discussed above. For example, the thermoelectric wire 124 can be foil- or film-based instead of wire-based. For example, a thermocouple 10 in a thermoelectric tube 127 may not be fabricated on the tube 127 itself, but it may just be provided inside the tube 127, e.g. as illustrated in FIG. 32 (a). Other types of prior art thermopiles can be used in embodiments of the present invention. As an example, an off-the-shelf thermopile is shown in FIG. 32(b) inside a thermoelectric tube 127, wherein thermoelectric legs are located between two ceramic plates 141, 142.

It is an advantage of a TEG 40 according to embodiments of the present invention that it can be a user-friendly wearable and flexible small-size TEG 40.

It is to be understood that all shown embodiments are just a few examples of possible TEGs 40. All shown elements can be used in different combinations, quantities, shapes, sizes and sequences.

Also, technical applications are feasible, wherein flexibility of the TEG 40 may be advantageous for placing the TEG 40 on a curved or bending surface.

The direction of the heat flow can be different; even in cases where the TEGs are provided on a body of a human beings: at ambient temperatures exceeding the skin temperature or at high level of irradiation with e.g. direct sunlight, the heat flow can be reversed and flow from the ambient into the TEG 40.

**Claims**

1. A thermoelectric system comprising:

   - a flexible structure (96, 121), and
   - at least one thermocouple unit (120) integrated in or attached to the flexible structure (96, 121), each thermocouple unit (120) comprising at least one thermocouple (10) and at least one radiator element (90) thermally connected to a first end (10a) of the thermocouple (10),
   wherein the at least one radiator element (90) is flexible.

2. A thermoelectric system according to claim 1, wherein the thermocouple unit (120) further comprises an electrically insulating joint (93) for electrically insulating but thermally connecting the thermocouple (10) and the flexible radiator element (90).

3. A thermoelectric system according to any of the previous claims, wherein the flexible radiator element (90) has a wire shape.

4. A thermoelectric system according to any of claims 1 or 2, wherein the flexible radiator element (90) has a film shape.

5. A thermoelectric system according to any of the preceding claims, wherein the flexible radiator element (90) comprises an area enlargement element (98) for improving heat flow through the thermocouple (10).

6. A thermoelectric system according to any of the preceding claims, wherein the at least one thermocouple unit (120) comprises a plurality of thermocouples (10) electrically connected in series by means of electrically conductive elements (91).

7. A thermoelectric system according to claim 6, wherein the thermocouple unit (120) further comprises a thermal shunt (97) for thermally connecting second ends (10b) of the plurality of thermocouples (10).

8. A thermoelectric system according to any of the preceding claims, wherein the thermocouple unit (120) further comprises at least one spacer (125) for providing at least a predetermined distance between a heat source and the thermocouples (10).

9. A thermoelectric system according to any of the preceding claims, wherein the flexible structure (121) comprises textile material.

10. A thermoelectric system according to any of claims 1 to 8, further comprising a textile layer (38) arranged at one side (122) of the flexible structure (96) so as to cover the first ends (10a) of the thermocouples (10).

11. A thermoelectric system (40) according to claim 10, further comprising a heat distribution element (74) arranged between the thermocouples (10) and the textile layer (38).

12. A method for fabricating a thermoelectric system (40), comprising:

   a) providing a flexible structure (96, 121);
   b) providing at least one thermocouple unit (120) comprising at least one thermocouple (10) and at least one flexible radiator element (90) thermally connected to a first end of the thermocouple (10),
   c) integrating or attaching the at least one thermocouple unit (120) into or to the flexible structure (96, 121)

13. A method according to claim 12, wherein providing at least one thermocouple unit (120) comprises providing a thermoelectric wire with an alternating pattern of different elements electrically connected to one another in the following sequence: a first thermocouple leg (11), a first electrically conductive element (92), a second thermocouple leg (12) and a second electrically conductive element (91).

14. A method according to claim 13, wherein integrating or attaching the at least one thermocouple unit (120) into or to the flexible structure (96, 121) comprises weaving the thermoelectric wire into the bendable or flexible structure (121) such that the first resp. second electrically conductive elements (91, 92) are arranged at least partly at different sides (122, 123) of the flexible structure (121).

15. A method according to claim 12, wherein providing a flexible structure comprises providing a thermally and electrically insulating foil or tape (96), wherein providing at least one thermocouple unit (120) comprises providing at least two thermocouples (10) on the foil or tape (96) and electrically connecting the at least two thermocouples (10) in series by means of an electrical connection (91), the method further comprising providing at least one patterned thermally conductive layer (81) for forming at least one radiator element (90), and thermally connecting the patterned thermally conductive layer (81) to first ends (11 a, 12a) of the thermocouple legs (11, 12) of the thermocouples (10).

**FIG. 1**

**FIG. 2**

**FIG. 3**

FIG. 4

FIG. 5

FIG. 6

120

90

92

96

12

11

91

10a

10b

97

FIG. 7

FIG. 8

FIG. 9

FIG. 10

FIG. 11

**FIG. 12**

(a)                              (b)

**FIG. 13**

FIG. 14

FIG. 15

FIG. 16

FIG. 17

**FIG. 18**

**FIG. 19**

**FIG. 20**

120         120

1202   1201   1202   1201

**FIG. 21**

120         120

A

A'

90         90

**(a)**

90

A

80

81

96, 100

**(b)**

**FIG. 22**

**FIG. 23**

**FIG. 24**

40

**FIG. 25**

FIG. 26

FIG. 27

120

90, 92

96

121

11, 12

92, 94

11, 12

91, 97

126, 127, 96

61

**FIG. 28**

40

121, 38

74

128

11, 12

126, 127, 96

**FIG. 29**

FIG. 30

FIG. 31

(a)                              (b)

FIG. 32

# EP 2 498 310 A2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20040025930 A

- EP 1970973 A

### Non-patent literature cited in the description

- **V. LEONOV.** Smart wireless sensors integrated in clothing: an electrocardiography system in a shirt powered using human body heat. *Sensors and Transducers Journal,* 2009, vol. 107 (8), 165-176